# EUROPEAN PATENT APPLICATION

(11) **EP 1 833 168 A1**
(43) Date of publication of application: **12.09.2007**
(21) Application number: 05822388.4
(22) Date of filing: 27.12.2005
(51) Int. Cl.: H03M 1/76, H03K 19/0185

(54) **SEMICONDUCTOR DEVICE AND LEVEL SHIFTING CIRCUIT**

(30) Priority: 28.12.2004 JP 2004378375
(71) Applicant: Uchida, Yasuhisa, Kitakyushu-shi, Fukuoka, 807-0851 (JP)
(72) Inventor: Uchida, Yasuhisa, Kitakyushu-shi, Fukuoka, 807-0851 (JP)
(74) Representative: Johnson, Terence Leslie
(86) International application number: PCT/JP2005/023914
(87) International publication number: WO 2006/070811

(57) **Abstract**

Many bit-ization also offers the semiconductor device which suppresses increase of chip size.
Part voltage of the voltage produced between potential VH and potential VL is carried out,
high electric strength digital to analog converter 1 in which an output of either of plural potentials 3-9 produced with part voltage based on the input signal (D0-DN-1) is possible,
plural elements 11 and 13,
output elements 15,
it has level shift part 17 which carries out the level shift of the potential of an input signal to potential required in order that output elements 15, plural elements 11, and each of 13 may operate, and impresses it to it. grouping of plural potentials 3-9 is carried out to the order of a potential level at plurality,
the voltage between the potentials of the group which provides and corresponds corresponding to each group is applied, and each of plural elements 11 and 13 operates.
either of the potentials in the group which corresponds based on an input signal is outputted,
the voltage between VH and VL is applied, and output elements 15 operate, and output either of the potentials in which the output of plural elements 11 and 13 is possible based on an input signal.

## Description

### Technical field

This invention relates to the semiconductor device which outputs any of plural potentials which carried out part voltage of a certain potential difference, and were produced they are, and the level shift circuit which carries out the level shift of the potential of an input signal.

### Background art

In recent years, digitization progresses, and a display unit also digitizes a video signal and is dealt with.
The signal of this digital value is changed into an analog value, and in order to supply a display unit, the digital to analog converter (DAC) is used.
High-speed conversion is required of this DAC.
Usually, the reference voltage level which was created by criteria resistance of the 2 rise n-th power in the case of DAC of n bit is used as an output value.
There are various methods as a method of taking out a reference voltage level to an output.
Typical tow methods which are use less element are shown below.

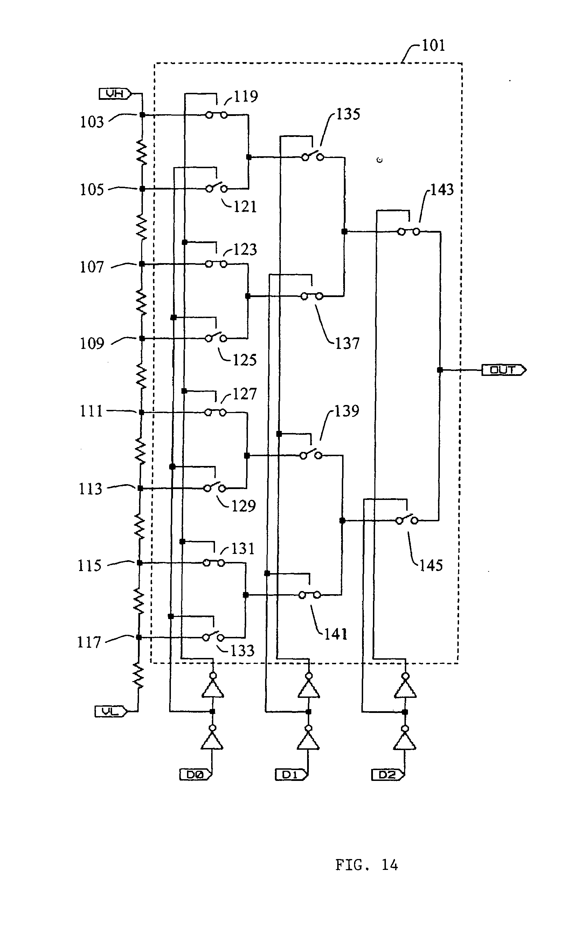

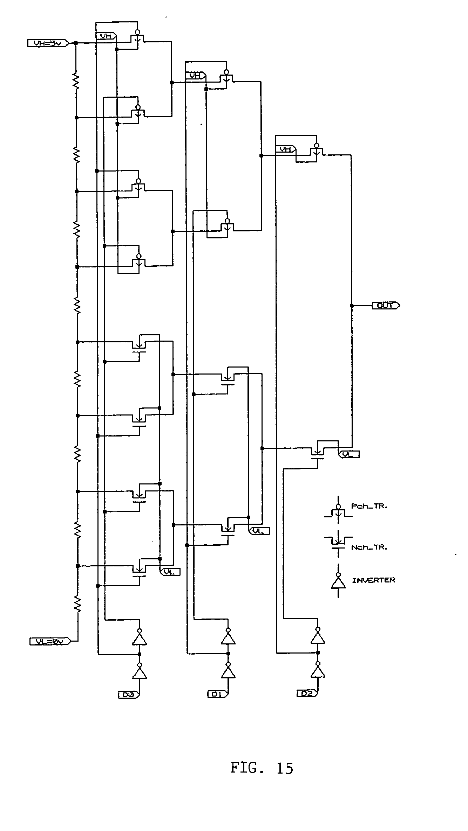

One method is the method of connecting with multi stage in the shape of a tournament, and constituting the switch realized with a transistor etc., as shown, for example in Fig. 14 (for example, refer to nonpatent literature 1).
When the voltage difference between high potential VH by the side of a power supply and low potential VL is small, this composition is used so that it may express using the below-mentioned figure 15.

Fig. 14 is a figure showing decoder circuit 101 by a tournament method in case input data is the digital value of a triplet.

In Fig. 14, resistance division of between voltage VH and voltage VL is carried out.
Based on input data D0-D2, either of potentials 103-117 which part voltage were carried out and were produced is chosen by decoder circuit 101, and is outputted.
Decoder circuit 101 is constituted by connecting switches 119-145 to multi stage in the shape of a tournament.

Specifically, switches 119-133 which constitute the 1st step are connected to potentials 103-117 which part voltage was carried out, respectively and were produced.
Each of switches 119, 123, 127, and 131 outputs corresponding potentials 103, 107, 111, and 115, when input data D0 is "H", and when input data D0 is "L", it does not perform a potential output.
Each of switches 121, 125, 129, and 133 outputs corresponding potentials 105, 109, 113, and 117, when input data D0 is "L", and when input data Do is "H", it does not perform a potential output.

Each of switches 135-141 which constitute the 2nd step are connected to switches 119-133 which constitute the 1st step by the following relations.
When input data D1 is "H", switch 135 outputs the potential which switch 119 or switch 121 outputs, and switch 139 outputs the potential which switch 127 or switch 129 outputs.
Switches 135 and 139 do not perform a potential output, when input data D1 is "L."
When input data D1 is "L", switch 137 outputs the potential which switch 123 or switch 125 outputs, and switch 141 outputs the potential which switch 131 or switch 133 outputs.
Switches 137 and 141 do not perform a potential output, when input data D1 is "H".

Each of switch 143 which constitutes the 3rd step nearest to the output side, and switch 145 is connected to switches 135-141 which constitute the 2nd step by the following relations.
Switch 143 outputs the potential which switch 135 or switch 137 outputs, when input data D2 is "H", and when input data D2 is "L", it does not perform a potential output.
Switch 145 outputs the potential which switch 139 or switch 141 outputs, when input data D2 is "L."
Switch 145 does not perform a potential output, when input data D2 is "H".

And decoder circuit 101 outputs the potential which either of switches 143 and 145 outputs as an output signal (OUT).
For example, when input data D0, D1, and D2 are "H", "L", and "H", respectively, switches 119, 123, 127, and 131, and 137, 141 and 143 output the potential which corresponds, respectively.
On the other hand, switches 121, 125, 129, 133, 135, 139, and 145 do not perform a potential output.
As a result, potential 107 outputted by switches 123, 137, and 143 is outputted as an output signal (OUT) by decoder circuit 101.
As mentioned above, a tournament method serves as DAC realizable with the minimum element number, in order that the array of a switch may serve as a decode function.

Fig. 15 is a circuit diagram which constituted the switch from a low electric strength switch transistor in Fig. 14.

As a power supply, high potential is set to VH=5v and low potential is made into VL=Ov.
The power supply of INVERTER (logic circuit) is also made into VDD=5v and VSS=Ov.
In this case, "H"=5v and "L" =0v are supplied to the gate of the transistor in a decoder circuit.
The transistor chosen by input data D0-D2 turns on, and outputs the selected potential.
If VDD is 3v, the level shift circuit which changes 3v signals into 5v signals is required.

In Fig. 15, the transistor corresponding to switches 119, 121, 123, 125, 135, 137, and 143 of Fig. 14 are P channel transistors (Pch_Tr),
The transistor corresponding to switches 127, 129, 131,133, 139, 141, and 145 are N channel transistors (Nch_Tr).
Since Pch_Tr is set to ON when L=0v is supplied to the gate, and it is set to OFF when H=5v is supplied, ON resistance becomes small by the VH side.
Since Nch_Tr "is turned off' off when "it turns on" on when "H" is supplied to the gate, and "L" is supplied, ON resistance becomes small by the VL side.

Other DACs decode with the gate signal of a switch transistor.

Fig. 16 is a circuit diagram in the case of a triplet which decodes with the gate signal of a switch transistor.
By NAND or the NOR circuit connected to the gate of a switch transistor, it decodes, and one switch transistor "to turn on" is chosen and outputted.

Fig. 17 is a circuit diagram in 6 bits.
It connects in series and the decode circuit of a high order and the low-ranking decode circuit are formed into 6 bit.
In the circuit of this method, the series connection number of stages of the switch transistor from the selection potential point made from resistance division of power supplies VH and VL to an output can be lessened.

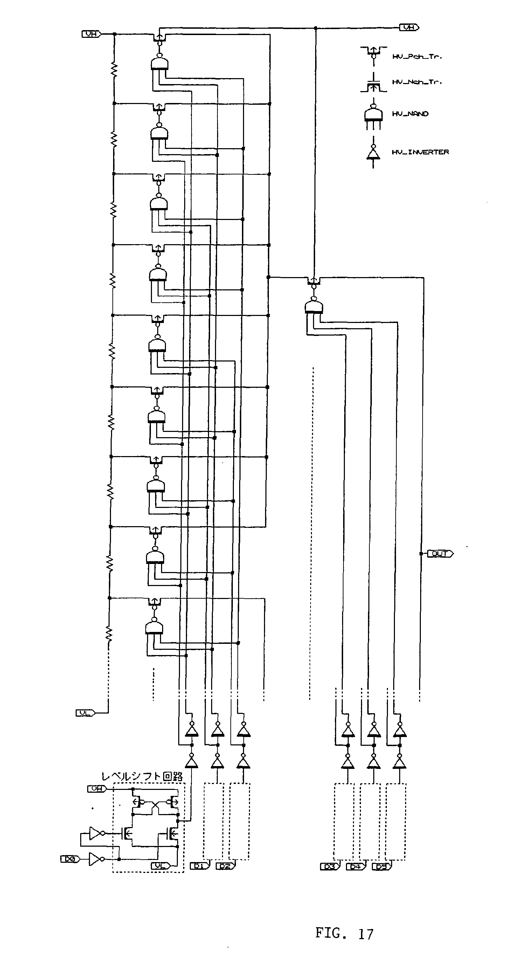

Fig. 17 shows the selection circuitry of nine potentials near VH, and, in the back, is omitted.
In the case of 6 bits, there is a selection potential point of 64.

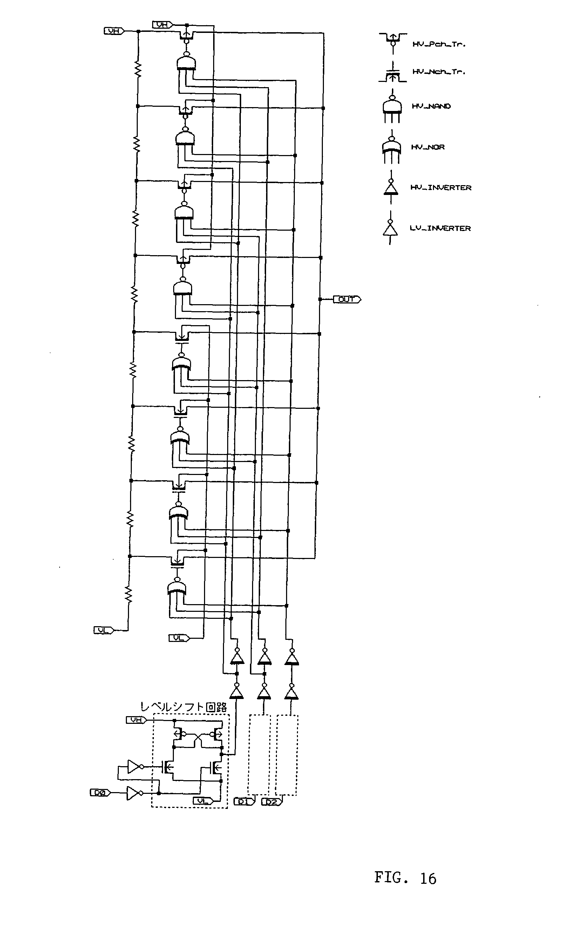

In the case of high voltage more than 5v, in Fig. 16 and Fig. 17, potential VH as a power supply is 15v, for example.
VL is taken as Ov.
Since VH is a high voltage, all the transistors in the switch transistor in a decoder circuit and a NAND circuit, a NOR circuit, an INVERTER circuit, and a level shift circuit etc. comprise high resisting pressure transistor HV_Tr.
ON resistance of HV_Tr is large, near the intermediate voltage of VH and VL, the substrate bias effect is also added and ON resistance becomes large further.
In this case, both Pch_Tr and Nch_Tr may be made into parallel connection, and may be used for a switch transistor.
Input data is 5v (or 3v) signal, is changed into 15v by the level shift circuit, and is used.

Nonpatent-literature 1: David Johns, et.al , "Analog Integrated Circuit Design", John Wiley & Sons Inc, November 15, 1996, p.463-465.
The indication of an invention

### Object of the Invention

By the way, highly-minute-izing and many gradation-ization are demanded in large-sized display units, such as television and OA equipment, now.
Simultaneously, low-pricing is also required by competition between companies, or saturation of a market.
Highly minute-ization means the increase in a pixel number, and means the increase in the number of DAC which supplies analog voltage to a pixel.
It comprises a subpixel of (red R) (green G) (blue B) 3 color, and 1 pixel is LDAC necessity at 1 subpixel.
Many gradation-ization means many bit-ization of DAC.
The high voltage is used and, therefore, DAC (HV_DAC) for high voltages using high electric strength transistor HV_Tr is required of a large-sized display unit.
What accumulated hundreds of DACs on one chip is called a driver IC.
In the large-sized display unit, tens of [of this driver IC] are used from about ten pieces.

If HV_Tr is used for tournament method DAC, in the case of DAC of n bit, the switch by HV_Tr of n stage will be connected in series, for example.
Therefore, ON resistance of DAC is large and produces an obstacle for high-speed conversion performance.
By said substrate bias effect, Pch_Tr of a switch transistor and Nch_Tr combined use are indispensable near the intermediate voltage of VH and VL.
Therefore, the element number which constitutes DAC increases.

When it decodes with the gate signal of a switch transistor and the series connection number of stages of a switch transistor is reduced, NAND and a NOR circuit must also be made many inputs.
As a result, the series connection of HV_Tr is constituted within NAND or a NOR circuit.
Therefore, Vt (threshold voltage) of a transistor goes up according to the substrate bias effect, and faults, such as a malfunction, arise.
In order to prevent this, in the case of 4 or more input, decomposing into the logic of 3 or less input etc. is made.
However, an element number increases in this case.
DAC size will be expanded if HV_Tr with big device size is used abundantly. It has great influence on the chip size which accumulated hundreds of DACs.

Thus, in prior art, the formation of many gradation was very difficult in respect of chip size, or cost and performance on the formation of many bits, and a display unit.

The purpose of this invention is to offer the semiconductor device which suppressed increase of chip size also in the formation of many bits.
The purpose of this invention is to offer the semiconductor device which performance and certainty of operation can also secure.

Other purposes of this invention are to offer a level shift circuit suitable for the above-mentioned semiconductor device.

### Means for solving problem

The invention concerning Claim 1 carries out part voltage of the voltage between the 1st potential and the 2nd potential higher than the 1st potential.
It is a semiconductor device in which an output of either of plural potentials produced with part voltage based on the input signal is possible.
Grouping of plural potentials produced with said part voltage is carried out to the order of a potential level at plurality,
Plural elements in which an output of either of the potentials in the group which each is provided corresponding to said each group, and corresponds based on an input signal is possible,
Based on an input signal, the output elements in which an output of either of the potentials in which the output of said two or more elements is possible is possible,
Have the potential of an input signal and the level shift means in which a level shift is possible [said output elements]
The voltage between said 1st potential and said 2nd potential is impressed, and operate, and the voltage between the potentials of a corresponding group is impressed and said two or more elements operate, respectively.
The level shift of the potential of an input signal is carried out to potential required in order that each of said output elements and two or more of said elements may operate, and said level shift means impresses it to it.

Thus, the voltage between the 1st potential and the 2nd potential is impressed to the output elements.
[each device in two or more elements] if the voltage between the 1st potential and the 2nd potential is a big value, although what is called a high resisting pressure semiconductor device is needed
it is only sufficient that the voltage between the potentials of the group used as a value smaller than the voltage between the 1st potential and the 2nd potential which corresponds, respectively is applied, and what is called a low resisting pressure semiconductor device can be used, and it is not necessary to use a high electric strength semiconductor device by advancing grouping.
As a result of being able to use a low electric strength semiconductor device especially, even if the number of stages of multi stage composition increases for the formation of many bits, ON resistance in the switch transistor used as a device is small.

The above-mentioned semiconductor device is built into a digital to analog converter, an analog-to-digital converter, a driver, a decoder, etc., and can be used.
It may be included in the display unit (for example, LCD device) with which many bit-ization progresses, and may be used for the power supply by which high-voltage-ization is accompanied.

The invention concerning Claim 2 is a semiconductor device according to claim 1,
the device of said plural elements is low electric strength from the device of said output elements.

The invention concerning Claim 3 is a semiconductor device according to claim 1 or 2.
2n potential is contained in the group of the potential to which at least one elements of said plural elements correspond, n steps of plural devices are put in order, it is constituted, and the device of an i-th power individual of 2 is contained in the i-th (i is an integer below or more 1n).

The invention concerning Claim 4 is a semiconductor device according to claim 1 or 2,
at least one elements of two or more of said elements contain the device constituted by putting m steps of n devices in order to several n and integer m beyond log₂n of potential which are included in the group of corresponding potential.

The invention concerning Claim 5 is a semiconductor device according to claim 1 or 2, and said each elements have a latch means as which an output idle state or an output possible state is chosen based on the reset signal inputted.

The invention concerning Claim 6 is a semiconductor device given in either of Claims 1-5, and said level shift means generates the output signal of required potential directly based on the potential of the inputted input signal, and it outputs.

The invention concerning Claim 7 is a semiconductor device given in either of Claims 1-6, and said level shift means comprises a device of low resisting pressure rather than the device of said output elements.

The invention concerning Claim 8 is a semiconductor device given in either of Claims 1-7, and has a level shift means between the elements by which said level shift means is located between the 1st elements and the 2nd elements which adjoin mutually.

The invention concerning Claim 9 is a semiconductor device according to claim 8, carries out the level shift of the potential with which said level shift means between the elements is added to said 2nd elements to potential required in order that said 1st elements may operate, and is impressed.

The invention concerning Claim 10 carries out part voltage of the voltage between the 1st potential and the 2nd potential higher than the 1st potential,
the semiconductor device in which an output of either of two or more potentials produced with part voltage based on the input signal is possible. grouping of plural potentials produced with said part voltage is carried out to the order of a potential level at plurality,
plural elements in which an output of either of the potentials in the group which each is provided corresponding to said each group, and corresponds based on an input signal is possible,
based on an input signal, have the output elements in which an output of either of the potentials in which the output of said two or more elements is possible is possible, and [said output elements]
the voltage between said 1st potential and said 2nd potential is impressed, and it operates, and the voltage between the potentials of a corresponding group is impressed and said plural elements operate, respectively.

The invention concerning Claim 11 is a level shift circuit which is a level shift means in a semiconductor device given in either of Claims 1-9,
the capacitor means as which an input signal is inputted,
have a latch circuit linked to said capacitor means, and [said latch circuit] answer that the input signal of the 3rd potential was inputted into said capacitor means, and generate the output signal of the 5th potential directly and it is outputted.
rather than said 3rd potential, it answers that the input signal of the 4th potential that is high potential was inputted into said capacitor means, and the output signal of the 6th potential is generated directly and outputted.

Such a level shift circuit connects composition continuously, and the level shift of gradual potential is also possible composition, and it can supply the voltage by different potential needed into each group.

In the present invention, the elements may be realized using the silicon-on-insulator (Silicon On Insulator) art which makes a transistor on insulators, such as glass.

### EFFECT OF THE INVENTION

As mentioned above, according to the semiconductor device of this invention, many bit-ization progresses, and with the whole device, even if it is a case where high electric strength is required, a low electric strength semiconductor device can be used.
Since it is not necessary to use a high electric strength semiconductor device, chip size can be made small.
In connection with it, cost can also be made low.
As a result of being able to use a low electric strength semiconductor device, even if the number of stages of multi stage composition increases for the formation of many bits, ON resistance of a switch transistor can be made small.
Therefore, high-speed conversion performance does not fall.

According to the level shift circuit of this invention, composition is connected continuously and the level shift of gradual potential is also possible.
Since the voltage by different potential needed into each group can be supplied by the low voltage, a low electric strength semiconductor device can be used also in a latch circuit.
While not using a high electric strength semiconductor device and making chip size small, cost can also be made low and will become positive about operation.
In order to be able to cut the dc component of the input signals and to use an alternating current component by using a capacitor means, the level shift of arbitrary voltage values also becomes possible.
Brief explanation of the drawings

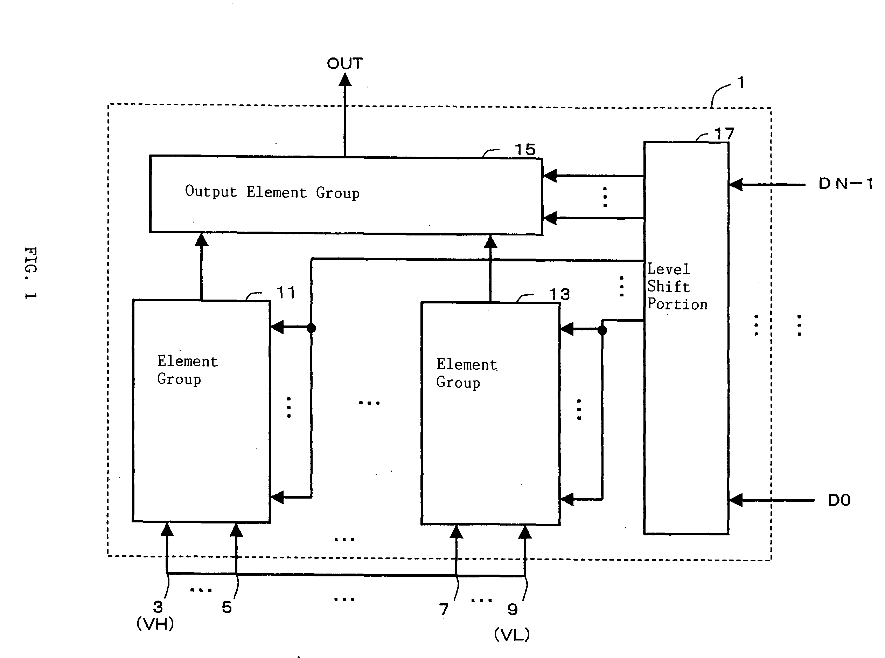

[Fig. 1] It is a schematic block diagram of high resisting pressure digital to analog converter HV_DAC concerning an embodiment of the invention.

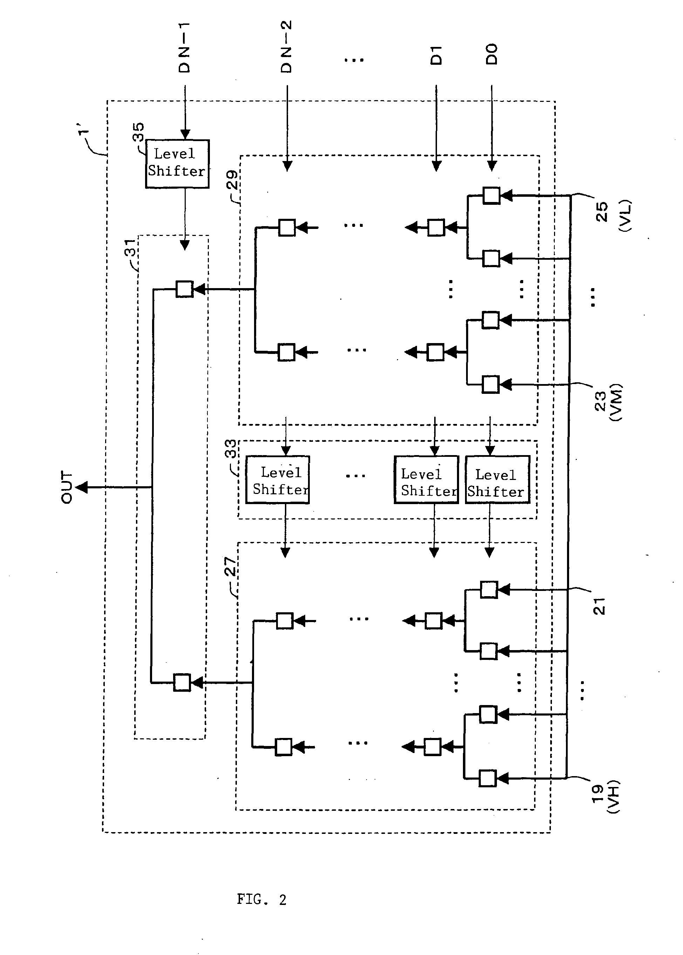

[Fig. 2] It is a figure showing one of the examples of HV_DAC of figure 1.

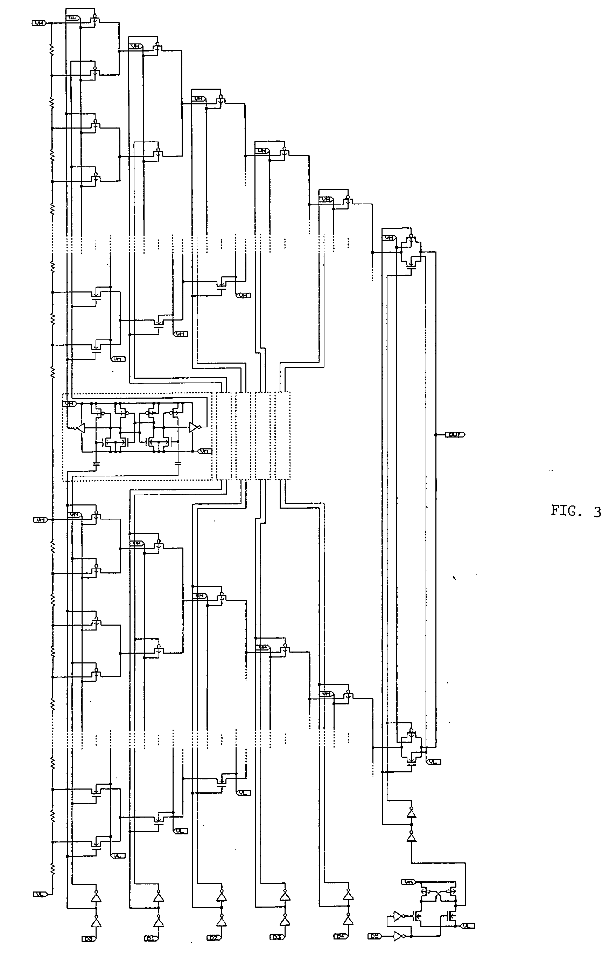

[Fig. 3] It is a figure showing what realized the example shown in figure 2 using the transistor.

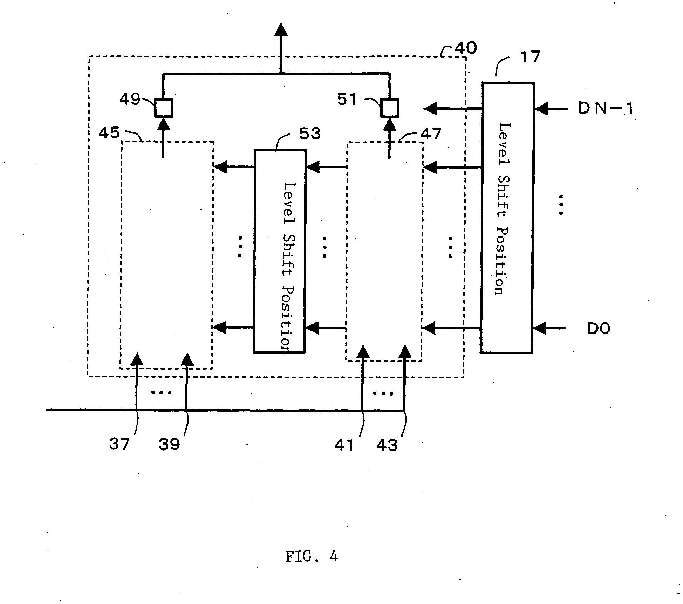

[Fig. 4] When elements 11-15 of figure 1 are multi stage composition, it is a figure showing the relation between the device in the elements (device which constitutes a final stage (stage nearest to an output) especially), and the voltage impressed.

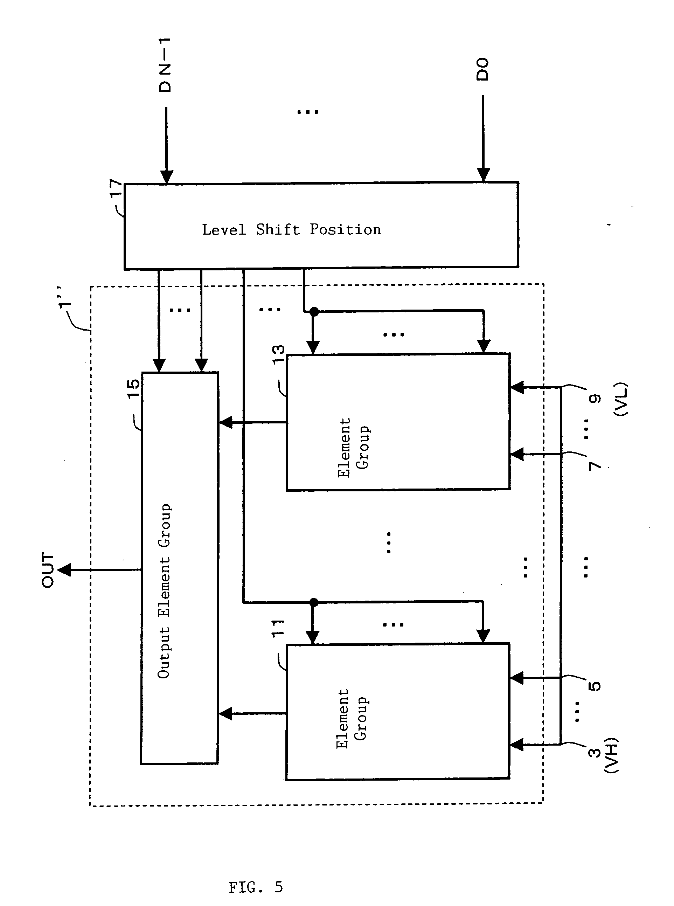

[Fig. 5] It is a figure showing that it is possible to have elements 11-13 and output elements 15 for HV_DAC.

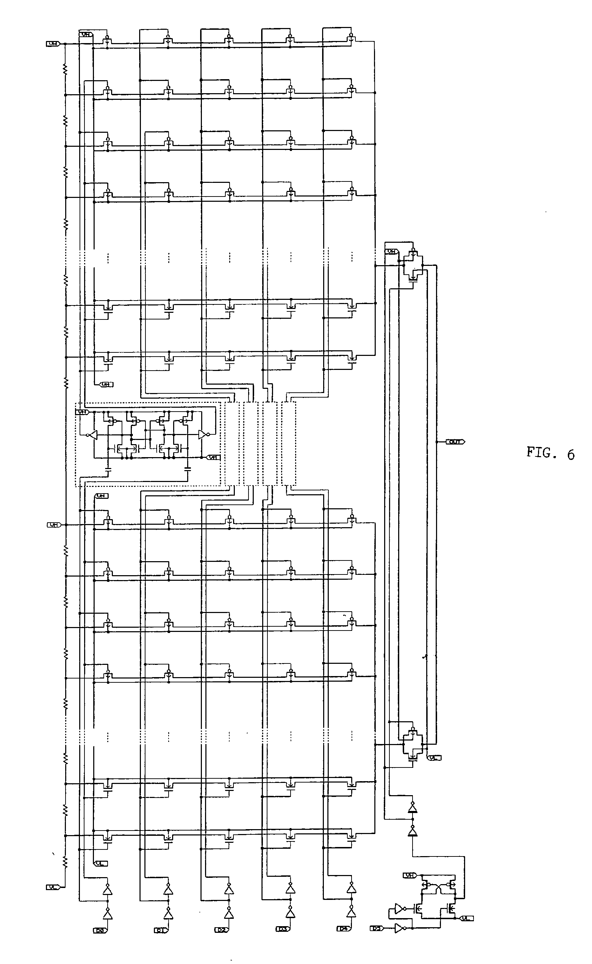

[Fig. 6] It is other one of the examples of HV_DAC of figure 1, and is a figure showing what put the switch transistor in order by the bit number for every selection potential.

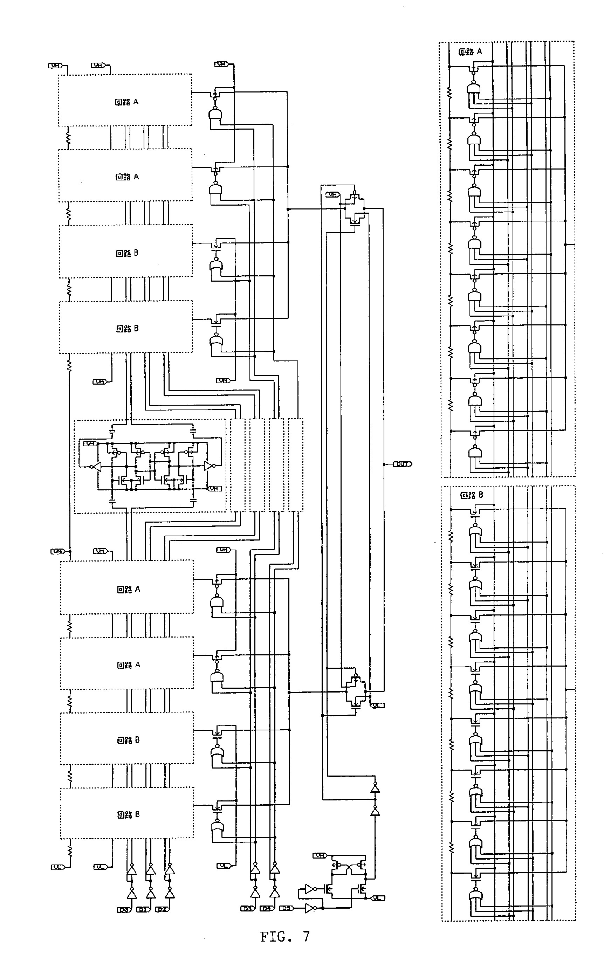

[Fig. 7] It is other one of the examples of HV_DAC of figure 1, and is a figure showing what decoded with the gate signal of the switch transistor and reduced the in-series number of stages of the switch transistor.

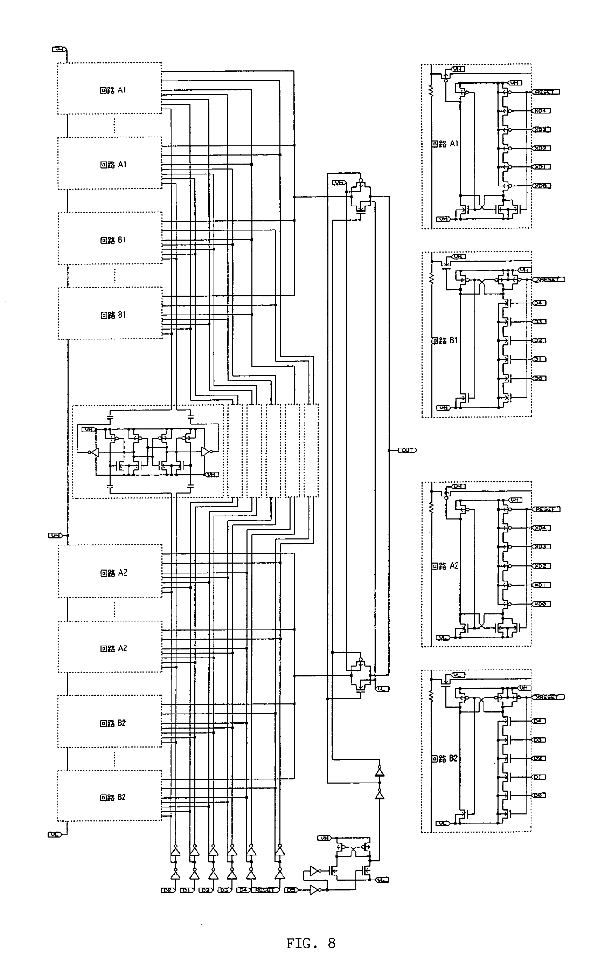

[Fig. 8] It is other one of the examples of HV_DAC of figure 1, and is a method which decodes the gate signal of a switch transistor.
   It is a figure showing what performed in a latch circuit not using NAND or NOR.

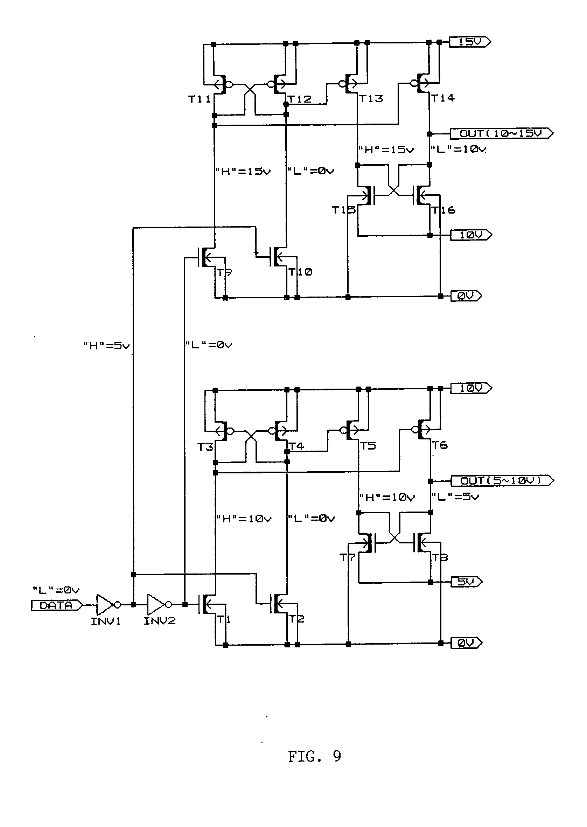

[Fig. 9] It is a potential state figure at the time of considering it as DATA= "L" as an initial state in the level shift circuit constituted using HV_Tr.

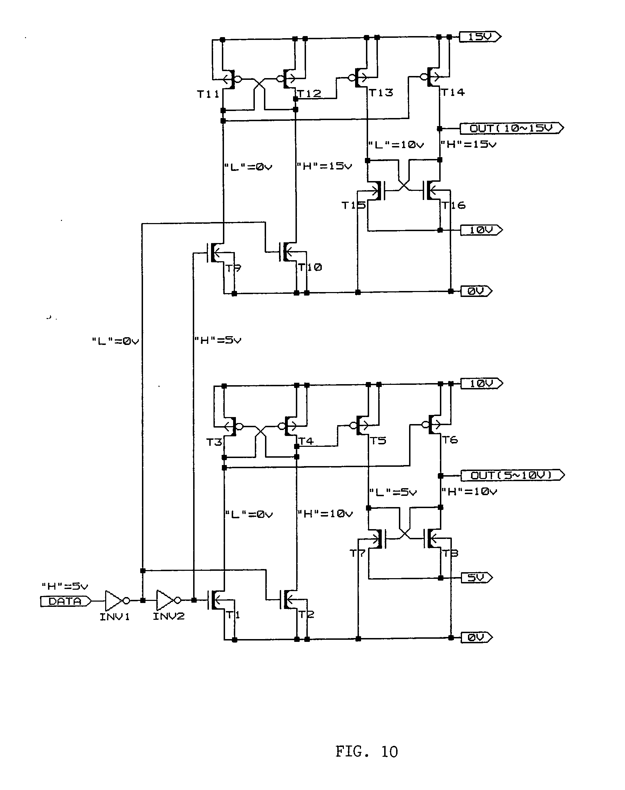

[Fig. 10] It is a potential state figure in the same level shift circuit as the circuit shown in figure 9 when DATA is set to "H."

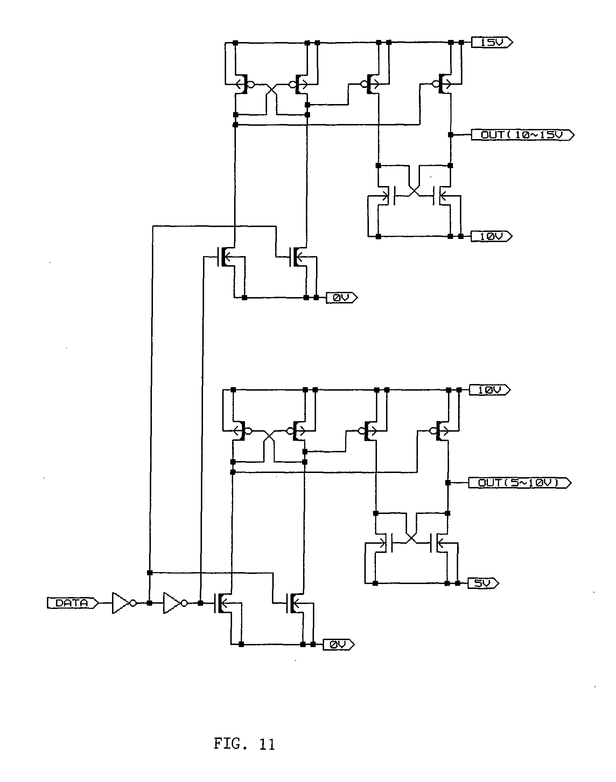

[Fig. 11] It is a figure in the level shift circuit constituted using HV_Tr showing the thing kept back bias from requiring.

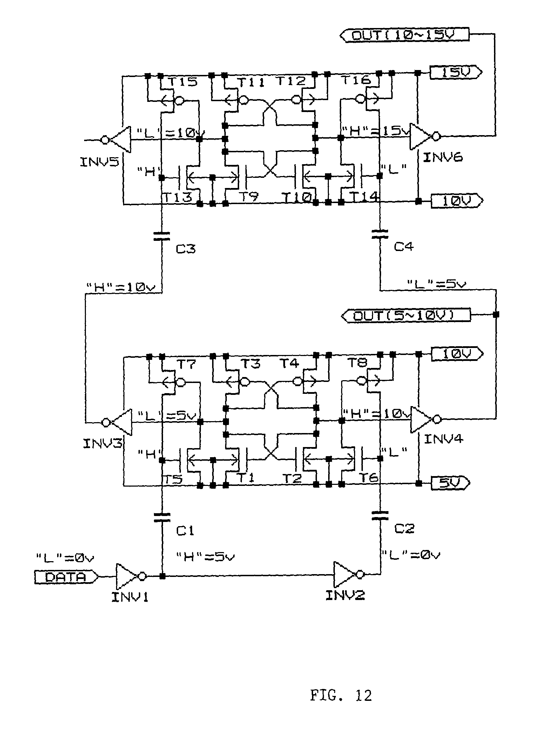

[Fig. 12] It is a potential state figure at the time of considering it as DATA="L" in the level shift circuit constituted using LV_Tr.

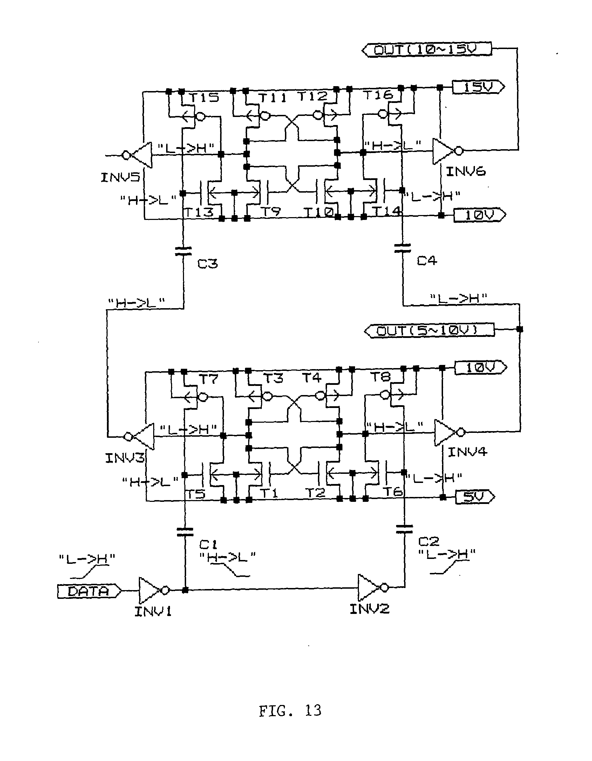

[Fig. 13] It is a figure in the same level shift circuit as the circuit shown in figure 12 showing the case where DATA changes from "L" to "H".
[Fig. 14] It is a figure showing decoder circuit 101 by a tournament method in case input data is the digital value of a triplet.
[Fig. 15] In figure 14, although the switch was transposed to the transistor, it is a figure showing operation.
[Fig. 16] It is a circuit diagram in the case of a triplet which decodes with the gate signal of a switch transistor.
[Fig. 17] Decode with the gate signal of a switch transistor like figure 16, and it is a circuit diagram in 6 bits.

### Explanations of letters or numerals

- 1 ....: Decoder circuit
- 11 ...: Elements
- 13 ...: Elements
- 15 ...: Output elements
- 17 ...: Level shift part
The best form for inventing

Fig. 1 is a schematic block diagram of the high resisting pressure digital to analog converter (HV_DAC) concerning an embodiment of the invention.

In Fig. 1, voltage of the voltage between the 1st potential and the 2nd potential higher than the 1st potential is carried out for 3 to 9 minutes.
Here, potential 3 is potential VH and potential 9 is potential VL.
An output of either of plural potentials 3-9 produced with part voltage based on input signal D0 - DN-1 is possible for decoder circuit 1.

Plurality potentials 3-9 are grouping in plural groups like potentials 3-5, ..., potentials 7-9.

Decoder circuit 1 is provided with plural elements 11-13, output elements 15, and level shift parts 17.

An output of either of the potentials in the group which is provided corresponding to said each group, respectively, and corresponds based on an input signal is possible for plural elements 11-13.
In Fig. 1, an output of either of potentials 3-5 is possible for elements 11, and they are the same about other elements.

Output elements 15 output either of the potentials which said plural elements 11-13 output based on an input signal.

Level shift part 17 carries out the level shift of the potential of an input signal (D0-DN-1).

Then, operation of HV_DAC of Fig. 1 is explained.

The voltage produced between the 1st potential VL and the 2nd potential VH is applied to output elements 15.
The voltage between the potentials of the group which corresponds, respectively is applied to plural elements 11-13.
For example, the voltage between potentials 3-5 is applied to elements 11.

As for output elements 15 and plural elements 11-13, a pMOS transistor and a nMOS transistor are used as a device.
These transistors need a different area from a substrate in a silicon substrate.
Well which is the area is more disengageable than substrate potential, for example, is realized using a triple well process.
Or it realizes using the silicon-on-insulator (Silicon On Insulator) art which makes a transistor on insulators, such as glass.
The high voltage from the 1st potential VL to the 2nd potential VH is applied, and output elements 15 operate.
The output elements are realized, for example using transistors of high electric strength, such as high bolt transistor HV_Tr, etc.
To it, the voltage between the potentials of the group which corresponds, respectively is applied, and plural elements 11-13 operate.
These elements 11-13 are realizable using low bolt transistor LV_Tr etc., for example.
Since HV_Tr is used only for the transistor near an output (OUT), ON resistance from a selection potential point to an output is small.

Level shift part 17 carries out the level shift of the potential of an input signal (D0 - DN-1) to potential required in order that each of output elements 15 and plural elements 11-13 may operate.

Fig. 2 is a figure showing one of the examples of an embodiment of the invention.

In Fig. 2, part voltage of the voltage produced between the 1st potential VL and the 2nd potential VH is carried out to potentials 19-25.
Grouping of the potentials 19-25 is carried out to potentials 19-21 and potentials 23-25.
An input signal (D0 . DN-1) is input data of digital value, the potential corresponding to high potential"H" of 5v-10v which is more than 5v is VH, for example, and the potential corresponding to "L" sets it to VL.
And suppose that potential 19 is potential VH, potential 23 is potential VM and potential 25 is potential VL.

Decoder circuit 1' is provided with elements 27 and 29, output elements 31, level shift part group 33, and level shift part 35.
Elements 27 and 29 of Fig. 2 correspond to elements 11-13 of Fig. 1.
Output elements 31 of Fig. 2 correspond to output elements 15 of Fig. 1.
What combined level shift part group 33 and level shift part 35 of Fig. 2 corresponds to level shift part 17 of Fig. 1.

Elements 29 are a thing of multi stage composition which is shown, for example in Fig. 14.
The voltage produced between potential VM and potential VL is impressed, and elements 29 operate.
Therefore, based on an input signal (D0 - DN-2), an output of either of potentials 23-25 is possible for elements 29.

Level shift part group 33 carries out the level shift of the potential of an input signal (D0 . DN-2) to potential VH or potential VM, and applies it to elements 27.

Elements 27 are a thing of multi stage composition which is shown, for example in Fig. 14.
The voltage produced between potential VH and potential VM is impressed, and elements 27 operate.
Based on input signal D0 DN-2, an output of either of potentials 19-21 is possible for elements 27.

Level shift part 35 carries out the level shift of the potential of input signal DN to potential VH or potential VL, and applies it to output elements 31.

The voltage produced between potential VH and potential VL is applied, and output elements 31 operate.
Therefore, elements 31 output either of the potentials in which the output of elements 27 and 29 is possible based on input signal DN.

Fig. 3 is a figure showing what realized HV_DAC of Fig. 2 with the transistor.

It is referred to as VL=0v, VM=5v, and VH=10v in Fig. 3.
In Fig. 3, each switch is realized using the process more disengageable than substrate potential in well.
Or it realizes using said silicon-on-insulator art.
It is the same composition as LV_DAC of Fig. 14 between VL and VM.
Therefore, 0-5V of input data can be used as they are.
Between VM and VH is the same composition as LV_DAC of Fig. 14.
A Pch back gate is VH and a Nch back gate is VM.
The level shift of the input data signal is carried out, and a gate signal is made as a signal of "H"=10v and "L" =5v.
Thereby, the high electric strength between VM=5v and VH=10v can be created by low bolt transistor LV_Tr.
The high voltage more than 10v can be similarly created by LV_Tr.
The circuit more than 10v is omitted in Fig. 3.

In order to add the high voltage from VL=Ov to VH=10v to the transistor near an output (OUT), these transistors are created by HV_Tr.
Since HV_Tr is used for the circuit near an output (OUT), ON resistance from the selection potential point made from resistance division of VH, VM, and VL to an output is small.

Therefore, since it excels from a viewpoint of chip size and ON resistance becomes small further in order to create by LV_Tr whose size is smaller than HV_Tr first, HV_DAC of the many bits of Fig. 3 is excellent also from a viewpoint of performance.

When elements 11-13 of Fig. 1 are multi stage composition, it may constitute like elements 40 of Fig. 4.

Specifically based on an input signal, an output of either of potentials 37-43 is possible for elements 40 of Fig. 4.
Elements 40 have elements 45 which operate on the voltage produced between potential 37 and potential 39, elements 47 which operate on the voltage produced between potential 41 and potential 43, devices 49 and 51 which operate on the voltage produced between potential 37 and potential 43, and level shift part 53.
And based on an input signal, an output of potentials 37-39 or potentials 41-43 is possible for elements 45 and elements 47 respectively.
Based on an input signal, an output of either of the potentials in which the output of elements 45 and elements 47 is possible is possible for device 49 and device 51.
Level shift part 53 carries out the level shift of the voltage of an input signal, and impresses it to elements 45.
Thus, when elements 11-13 of Fig. 1 are multi stage composition, the voltage between the potentials of the group to which the device which constitutes a final stage at least corresponds is applied, and it operates.
Therefore, the circuit of this invention can perform circuitry according to the voltage value applied.

As shown in Fig. 5, decoder circuit 1" may not include level shift part 17, but may be provided with output elements 15 and elements n-13.

Fig. 6 shows the decode method which put the switch transistor in order by the bit number for every selection potential.
Although an element number increases more than a tournament method, since the transistor of this size is only put in order, there is an advantage to which arrangement becomes simple.

Also although a bit number increases and it is called LV_Tr, when ON resistance becomes large, it decodes with the gate signal of a switch transistor like HV_DAC, and the in-series number of stages of a switch transistor is reduced.
Although Fig. 7 shows the case where 6 bits is divided into 3-2-1, it may be divided into 5-1.
The logic (NAND.NOR) of 4 or more inputs is possible for LV_Tr.
Since it is not necessary to change LV_Tr into the logic of 3 or less inputs, an element number does not increase.
The circuit can design n bit by performance, an element number, and the ratio that takes both sides into consideration and serves as best.

Fig. 8 shows the method which decodes the gate signal of a switch transistor.
Fig. 8 shows the method held in a latch circuit not using NAND or NOR.
A RESET signal is newly needed and an element number also increases.
The difference among circuits 1 and 2 is only a difference in a use power supply.
Before deciding one selection potential part by decode, it is necessary to make all into non selection once by RESET.
Operation differs only in this portion from other decode circuits.
In a RESET period, all become non selection automatically.
If this circuit cancels RESET, data will be decoded automatically.
In this circuit, there are not RESET and an entry-of-data timing convention.
In Fig. 8, D0-D4 and RESET in circuits 1 and 2 are a signal (normal rotation signal) after passing two steps of inverters of signals D0-D4, and RESET, respectively.
XDO-XD4, and XRESET in circuits 1 and 2 are a signal (inversion signal) after passing the inverter of signals D0-D4, and RESET, respectively.

Power supplies VH and VL may differ from power supplies VDD and VSS of a logic circuit.
For example, it is VH=15v and VL=Ov and they are VDD=3v, VSS=Ov, etc.
In this case, the same HV_DAC as this embodiment can be constituted by using a level shift circuit.

Then, a level shift circuit is explained.
The level shift circuit can consider two things.
One is constituted using HV_Tr and other one is constituted only using LV_Tr.

Fig. 9 and Fig. 10 are figures showing operation of the level shift circuit constituted using HV_Tr.

First, Fig. 9 is a figure showing the case where it is considered as DATA="L" as an initial state.
The output of INVI is "H"=5v and the output of INV2 is "L"=0v.
Transistor T1 is "OFF" and T2 is "ON."
Since T2 is "ON", the drain voltage of T2 is 0v.
The gate of T3 is connected with the drain of T2, and, as for T3, the gate of T3 is set to "ON" by "L" =0V
Since T1 is "OFF", the drain voltage of T3 serves as 10v="H".
The gate of T4 is connected with the drain of T3, and T4 is set to "OFF."

Next, since it connects with the drain of T2, the gate of T5 is set to "ON", and since it connects with the drain of T3, the gate of T6 serves as "OFF."
Since T5 is set to "ON", the gate voltage of T8 is 10v.
Since this voltage is larger than source voltage 5v of T8 and it is larger than threshold voltage for a transistor "to turn on" on, T8 is set to "ON."
Since T8 is "ON", the drain voltage of T8 is set to 5v.
The gate of T7 is connected with the drain of T8, and, therefore, T7 is set to
"OFF."

If the above is summarized,
T1= "OFF"
T2="ON"
T3="ON"
T4="OFF"
T5= "ON"
T6="OFF"
T7="OFF"
It becomes T8="ON" and an output is set to 5v.

Similarly, it is also in the circuit of T9 to T16,
T9= "'OFF"
T10="ON"
T11= "ON"
T12="OFF"
T13= "ON"
T14="OFF"
T15= "OFF"
It becomes T16="ON" and an output is set to 10v.

Next, Fig. 10 is a figure showing the case where DATA becomes "H".
When DATA becomes "H", said all circuit states are reversed, 10v is outputted in the circuit of T1 to T8, and 15v is outputted in the circuit of T9 to T16.

However, there are two problems in the circuit of Figs. 9 and 10.
The first problem is having to carry out full amplification of DATA signal 0 - 5V at 0-10v, or 0-15v by the first rank (from T1 to T4 and T9 to T12) of a level shifter.
0-3v, etc. have the small amplitude of a DATA signal.
Since very big amplification degree is required when a power supply is required to the high voltage more than 15v, there is a possibility that faults, such as a malfunction, may arise.

The second problem is that there is the substrate bias effect of T7, T8, and
T15 and T17.
Usually, if substrate bias has not started (source voltage and back gate voltage are these potentials), threshold voltage is about 1v.
However, if substrate bias becomes large, threshold voltage for (a difference's being on source voltage and back gate voltage) and a transistor to turn on will also become high.
When the worst, it may become impossible to turn on a transistor.

The second problem of the above can be coped with, for example by the circuit of Fig. 11.
A process more disengageable than substrate potential is prepared and substrate bias is kept from starting Well in the circuit of Fig. 11.
However, the first problem is not solved in the circuit of Fig. 11.

Fig. 12 and Fig. 13 are figures showing operation of the level shift circuit constituted using LV_Tr.

First, Fig. 12 is a potential state figure at the time of considering it as
DATA="L."
T1, T3, and T2 and T4 form INVERTER, respectively.
As for a partner's input, in their input, these two INVERTER(s) form the latch circuit in a partner's output like their output.
T9, T11, and T10 and T12 are the same.
At the time of a power supply (v [5],v [10], 15v) injection, this latch circuit always outputted either "H" or "L", and is stable.

Here, T1 and T3_INV (INVERTER which TI and T3 form) output "L" =5V
T2 and T4_INV output "H"=10v, T9 and T11_INV output "L" =10V, and T10 and T12_INV output "H"=15v.

Since T1 and T3_INV are outputting "L" =5V, T7 is set to "ON", and the drain voltage of T7 is set to 10v.
And the gate voltage of T5 is set to "H"=10v, and T5 is set to "ON."
On the other hand, since T2 and T4_INV are outputting "H"=10v, T8 is set to "OFF."
The gate voltage of T6 is "L" voltage near 5v, and T6 assumes "It turns off."

T15 and T13 "are turned on" on similarly and the gate voltage of T13 turns into voltage near 15v.
T16 and T14 "are turned off' off and the gate voltage of T14 turns into voltage near 10v.

Next, Fig. 13 is a figure showing the case where DATA changes from "L" to "H".
The output of INVI is "L" from "H", and a voltage swing is 5v (AC component is 5v).
In capacitor C1, this amplitude drops the gate voltage of through T5.
It is decided by the resistance ratio of ON resistance of T7, and the impedance (= 1/• C) of C1 how many gate voltage of T5 will descend.
If ON resistance of T7 is set up more greatly enough than the impedance of C1, 5v descent of the gate voltage of T5 will be done mostly.
As a result, it becomes 5v="L" (DC10v-AC5v=5v), and T5 is set to "OFF."

On the other hand, 5v (AC component 5v) amplitude makes the output of INV2 into "H" from "L."
In capacitor C2, this amplitude raises the gate voltage of through T6.
If T6 "turns on" on and drops the gate voltage of T8 by this, T8 "will turn on" on and will increase the gate voltage of T6 further.
That is, positive feedback has started.
Thereby, T6 and T8 will be in "ON" state completely.
Therefore, the gate voltage of T6 is fixed to 10v="H".
If driving ability of T6 is enlarged here, the latch circuit made in T1, T3_INV and T2 and T4_INV can be reversed.
If a latch circuit is reversed and the output of T1 and T3 INV is set to "H"=10v, T7 "will be turned off" off and will carry out state maintenance of the gate voltage of T5 with "L" level.

The latch circuit which shaped the output of the latch circuit in waveform once by INV3 and INV4, and was similarly made from T9, T11_INV and TI0 and T12_INV through C3 and C4 is reversed.

Since DC voltage is cut by a capacitor and the latch circuit is reversed only of AC component, the level shift signal of arbitrary voltage values can be made from the signal of 0-5v.
If C3 is driven by INV1 and C4 is driven by INV2 except for the latch circuit of C1, C2, and 5-10v, it is also more possible than the signal of 0 - 5V to make the signal of 10-15v directly.

The transition time of LV logic is very short, and a RF.
Therefore, even if the impedance (= 1/• C) of capacitor C makes a capacitor small, it is considerably made to low impedance.
Therefore, the level shift circuit shown in Fig. 12 and Fig. 13 is small compared with the level shift circuit using HV_Tr.

In the case of a 6-bit device compares the conventional device (refer to Fig. 17) with the device (refer to Fig. 3) of the embodiment concerning the present invention, it becomes one sixth in 2 dimensions.

## Claims

1. Carry out part voltage of the voltage between the 1st potential and the 2nd potential higher than the 1st potential,
it is a semiconductor device in which an output of either of two or more potentials produced with part voltage based on the input signal is possible, grouping of plural potentials produced with said part voltage is carried out to the order of the potential level at plurality,
plural elements in which an output of either of the potentials in the group which each is provided corresponding to said each group, and corresponds based on an input signal is possible,
based on an input signal, the output elements in which an output of either of the potentials in which the output of said two or more elements is possible is possible,
have the potential of an input signal and the level shift means in which a level shift is possible [said output elements]
the voltage between said 1st potential and said 2nd potential is impressed, and operate, and the voltage between the potentials of a corresponding group is impressed and said two or more elements operate, respectively.
the semiconductor device which said level shift means carries out the level shift of the potential of an input signal to potential required in order that each of said output elements and two or more of said elements may operate, and is impressed.

2. The semiconductor device according to claim 1 whose device of said plural elements is low electric strength from the device of said output elements.

3. The semiconductor device according to claim 1 or 2 with which 2n potential is contained in the corresponding group of potential, at least one elements of said plural elements put n steps of plural devices in order, are constituted, and a 2ⁱ piece device is contained in "i" stage ("i" is an integer lager than 1 and smaller than "n").

4. The semiconductor device according to claim 1 or 2 containing the device constituted by at least one elements of two or more of said elements putting m steps of n devices in order to several n and integer m beyond log₂n of potential which are included in the group of corresponding potential.

5. The semiconductor device according to claim 1 or 2 with which said each elements have a latch means as which an output idle state or an output possible state is chosen based on the reset signal inputted.

6. A semiconductor device given in either of Claims 1-5 which said level shift means generates the output signal of required potential directly based on the potential of the inputted input signal, and is outputted.

7. A semiconductor device given in either of Claims 1-6 by which said level shift means is constituted from a device of low resisting pressure rather than the device of said output elements.

8. A semiconductor device given in either of Claims 1-7 which has a level shift means between the elements by which it is located between the 1st elements and the 2nd elements which said level shift means adjoins mutually.

9. The semiconductor device according to claim 8 which carries out the level shift of said level shift means between the elements to potential required in order that said 1st elements may operate and with which it impresses the potential impressed to said 2nd elements to it.

10. Carry out part voltage of the voltage between the 1st potential and the 2nd potential higher than the 1st potential,
it is a semiconductor device in which an output of either of two or more potentials produced with part voltage based on the input signal is possible, grouping of plural potentials produced with said part voltage is carried out to the order of the potential level at plurality, and each is provided corresponding to said each group,
plural elements in which an output of either of the potentials in the group which corresponds based on an input signal is possible,
based on an input signal, have the output elements in which an output of either of the potentials in which the output of said two or more elements is possible is possible, and [said output elements]
the semiconductor device with which the voltage between said 1st potential and said 2nd potential is impressed, and it operates, and the voltage between the potentials of a corresponding group is impressed, and said two or more elements operate, respectively.

11. (After an amendment)
The capacitor means as which it is a level shift circuit which is a level shift means in a semiconductor device given in either of Claims 1-9, and an input signal is inputted, have a latch circuit linked to said capacitor means, and [said latch circuit] answer that the input signal of the 3rd potential was inputted into said capacitor means, and generate the output signal of the 5th potential directly and it is outputted,
the level shift circuit which answers that the input signal of the 4th potential that is high potential was inputted into said capacitor means, generates the output signal of the 6th potential directly and outputs it rather than said 3rd potential.
